# EUROPEAN PATENT APPLICATION

(11) **EP 4 567 862 A1**
(43) Date of publication of application: **11.06.2025**
(21) Application number: 23214989.8
(22) Date of filing: 07.12.2023
(51) Int. Cl.: H01L 21/304, H01L 21/78, H01L 21/683

(54) **A METHOD FOR THINNING SEMICONDUCTOR DIES**

(71) Applicant: Imec VZW, 3001 Leuven (BE)
(72) Inventor: Kennes, Koen, 3050 Oud-Heverlee (BE); Phommahaxay, Alain, 1490 Court Saint Etienne (BE); Schoofs, Geert, 3090 Overijse (BE); Devriendt, Katia, 3211 Binkom (BE); Chukka, Rami Naidu, 3210 Linden (BE)
(74) Representative: Patent Department IMEC

(57) **Abstract**

One or more wafers (1,2) are provided, possibly having different thicknesses, each comprising a plurality of semiconductor dies (3). The wafers are attached to dicing tapes (7,8) and diced to produce separate dies (3) having a front side and a back side. The front sides of a plurality of dies are releasably attached to a carrier substrate (15) and are subsequently collectively thinned while attached to the carrier substrate. According to various embodiments, the dies (3) attached to the carrier substrate (15) originate from wafers (1,2) having mutually different thicknesses. The method enables thinning dies (3) to very low thicknesses and improves the capability of handling such thin dies during subsequent bonding processes.

## Description

### Field of the Invention

The present invention is related to semiconductor processing, in particular to the production of thinned semiconductor dies which are to be further handled and bonded to another die or substrate.

### State of the art.

In semiconductor processing, the importance of die-to-die or die-to-wafer bonding processes has increased due to the high prevalence of 3D integration schemes. One problem hereby is related to the die-coplanarity, i.e. the production of dies of equal thickness within very strict tolerances, which is essential in many stacking applications. Today, this is typically achieved at the level of the source wafer, i.e. the source wafer is thinned before the dies processed on the wafer are separated by a dicing step. Wafer level thinning is performed by back side grinding and CMP (chemical mechanical polishing) in which the grinding/CMP tolerance is set to be very strict, for example below 2 µm. However, when dies from multiple source wafers are used in the same application, all the source wafers need to maintain this same tight thickness tolerance which requires multiple processing steps per wafer. Such source wafers can be small coupons of about 50 or 100 mm in diameter, often used for processing III-V materials or Ga for example, as well as silicon wafers of different sizes (diameter 150 mm, 200mm or 300mm).

Populating a large wafer, for example a 300 mm Si wafer with dies from many different-sized source wafers therefore requires a high number of thinning and CMP operations, which increases the time and cost of the overall process. Moreover, the in-wafer total thickness variations of the source wafers are highly dependent on the incoming wafer quality and can be as high as 10µm, and the wafer thickness within a batch or between different batches can vary as much as +-25µm. These variations increase the difficulty of obtaining a uniform thickness between dies originating from difference source wafers.

Another problem is related to the obtainable die thickness. Source wafers are temporarily attached to a dicing tape fixed to a tape frame before grinding and CMP, which is then followed by the dicing step to obtain separate dies on tape. However, the obtainable die thickness is limited to higher thicknesses by the subsequent die-handling steps. A die pick-up from a tape frame requires the expansion of the tape frame by needles which can damage dies thinner than 20µm.

### Summary of the invention

The invention is related to a die thinning method as set out in the appended claims. One or more wafers are provided, possibly having different thicknesses, each wafer comprising a plurality of semiconductor dies. The one or more wafers are attached to dicing tapes and diced to produce separate dies having a front side and a back side. The front sides of a plurality of dies are releasably attached to a carrier substrate and are subsequently collectively thinned while attached to the carrier substrate. According to various embodiments, the dies attached to the carrier substrate originate from wafers having mutually different thicknesses. The method enables thinning dies to very low thicknesses and improves the capability of handling such thin dies during subsequent bonding processes.

The invention is in particular related to a method for thinning a plurality of semiconductor dies, said dies having a front side and a back side, the method comprising the consecutively applied steps of :
- producing one or more wafers, each wafer comprising a plurality of semiconductor dies,
- attaching the one or more wafers respectively to one or more dicing tapes,
- dicing the one or more wafers to obtain a plurality of separate dies on the one or more dicing tapes,
- transferring a plurality of said dies to a carrier substrate by removably attaching the front side of said dies to said carrier substrate,
- collectively thinning the dies attached to the carrier substrate from the back side of said dies.

According to an embodiment, a plurality of said wafers is provided, each wafer comprising a plurality of semiconductor dies, the wafers having at least two different thicknesses, and wherein dies originating from wafers having a different thickness are attached to said carrier substrate.

According to an embodiment, a releasable adhesive layer is produced on a surface of the carrier substrate and the dies are attached to said releasable adhesive layer. According to an embodiment, said releasable adhesive layer is formed of an inorganic dielectric material or an organic polymer material.

According to an embodiment, the thinning step comprises collectively grinding the dies on the back side of the dies.

According to an embodiment, after said grinding, the thinning step further comprises collectively applying chemical mechanical polishing on the back side of the dies.

According to an embodiment, the thickness difference between any two dies attached to the carrier substrate before the thinning step lies between 0 mm and 1.5 mm.

According to an embodiment, the distance between any two adjacent dies on the carrier substrate lies between 0 cm and 5cm.

According to an embodiment, the thickness of the dies after the thinning step is smaller than 3 µm.

The invention is equally related to a method for bonding multiple dies to a support substrate by an electrically conductive bond, comprising the steps of :
- thinning said multiple dies collectively by the method according to the invention, wherein said carrier substrate is now referred to as a first carrier substrate,
- releasably attaching the dies to a second carrier substrate,
- thereafter releasing the dies from the first carrier substrate,
- thereafter bonding the dies collectively to the support substrate,
- thereafter releasing the dies from the second carrier substrate.

The invention is equally related to a method for bonding multiple dies to a support substrate by an electrically conductive bond, comprising the steps of :
- thinning said multiple dies collectively by the method according to the invention,
- transferring the dies one by one from the carrier substrate to the support substrate.

According to an embodiment of the method for bonding multiple dies to a support substrate, the carrier substrate is transparent, the dies are attached to the carrier substrate by a light-releasable adhesive, and the dies are transferred one by one to the support substrate by illuminating the dies through the carrier substrate.

### Brief description of the figures

Figure 1 illustrates the preparation of separate dies originating from different source substrates.
Figures 2 to 4 illustrate the assembly and collective thinning of the dies on a carrier substrate.
Figures 3 to 8 illustrate the collective bonding of dies thinned by the method according to an embodiment of the invention.
Figure 9 illustrates die-to-wafer bonding of dies thinned by the method according to an embodiment of the invention.

### Detailed description of the invention

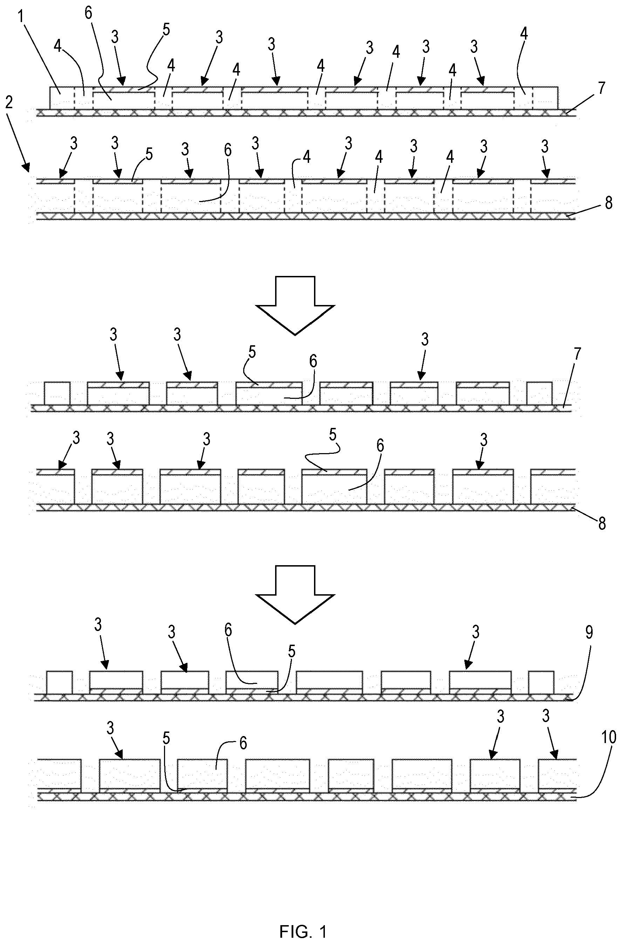

Figure 1 illustrates two wafers 1 and 2, each comprising a number of semiconductor dies 3 which have been processed on the respective wafers. The dies are separated by dicing lanes 4 extending between dotted lines indicated in the drawings. The wafers 1,2 and the dies 3 have a front side and a back side. The dies 3 comprise an active portion 5 at the front side and a bulk semiconductor portion 6 extending from the active portion 5 to the back side of the dies. The active portion 5 may include active devices arranged in a front end of line part of the active portion, interconnect levels arranged in a back end of line part, and contact terminals, such as bumps or planar contact pads embedded in a dielectric layer on the front surface of the dies 3. The active portion 5 may be less than 1 µm in thickness. The represented thickness of this active portion 5 is exaggerated in the drawings in order to distinguish it from the bulk portion 6.

The wafers 1 and 2 may have different dimensions as measured in the plane of the wafers. In the particular case shown, wafer 1 is smaller than wafer 2. Wafer 1 may be for example a 50 mm diameter coupon formed of III-V semiconductor material, while wafer 2, of which only a portion is shown, may be a 200 mm or 300 mm diameter Si wafer.

The back side of the wafers 1 and 2 is attached to respective dicing tapes 7 and 8, possibly after a thinning operation of the original process wafers from the back side thereof. The thickness of the wafers as attached to the dicing tapes may be a few millimetres or less than 1 mm. The thickness of wafer 1 is however different from the thickness of wafer 2, as seen in the drawings. Only two wafers are illustrated in Figure 1, but according to other embodiments of the invention, more than two wafers are provided on respective dicing tapes, wherein the additional wafers may have in-plane dimensions equal to or differing from wafers 1 and 2 and thicknesses equal to or different from the thickness of wafers 1 and 2. Within the context of the present description, the following definitions are applicable : the thickness of a wafer is defined as the average of the wafer thickness measured in the centre and on the edge of the wafer. According to various embodiments, for example depending on the thickness of the wafers, two wafers are defined as having different thicknesses, when their thickness, as defined above, differs more than 1 µm, more than 500 nm, more than 100 nm, more than 20 nm or more than 0 nm. According to embodiments, the maximum thickness difference between two wafers applied in the method of the invention is one of the following values : 20 µm, 100 µm, 5 µm, 1 mm, 1.5 mm. According to further embodiments, the difference in thickness between any two wafers applied in a method according to the invention and defined as having different thicknesses lies between any one of the lower limits and any one of the upper limits stated hereabove.

The method of the invention is however not limited to embodiments starting from 2 or more wafers having different thicknesses. The method is applicable also to a plurality of wafers having the same thickness but formed of different materials, as well as to a plurality of wafers having the same thickness and formed of the same materials, i.e. a plurality of identical wafers. Finally, the method is also applicable to a single wafer and to a plurality of dies 3 obtained by dicing said wafer.

As illustrated in the second stage shown in Figure 1, both wafers 1 and 2 are subjected to a dicing operation as known in the art, wherein the dies 3 are separated by sawing or cutting along the dicing lanes 4. This is preferably followed by a cleaning step to remove residues remaining after the dicing step and possibly to remove a protective layer (not shown) from the front surface of the dies 3. The dies 3 are now separate but still attached at their back side to the dicing tapes 7 and 8. The in-plane dimensions of the dies 3 may be in the order of a few millimetres to a few centimetres. As illustrated, these in-plane dimensions need not be the same for the plurality of dies originating from any of the wafers.

As shown in the third stage in Figure 1, the assemblies of dies 3 and dicing tapes 7 and 8 are flipped and the front side of the dies is removably attached to adhesive tapes 9 and 10 which may also be dicing tapes attached to a frame, followed by the removal of the dicing tapes 7 and 8. Such tape transfer operations are known in the art.

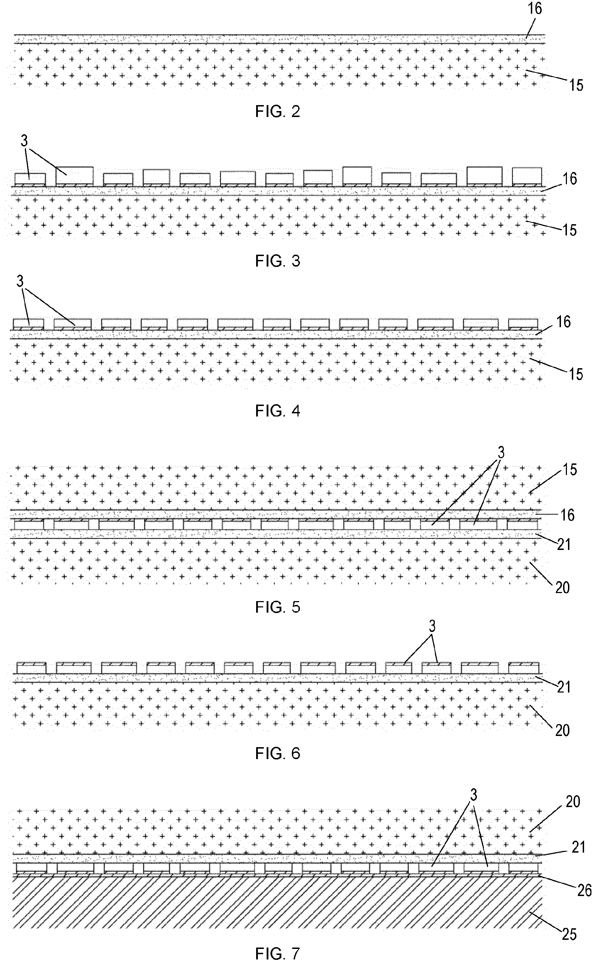

Reference is now made to Figure 2. A temporary carrier substrate 15 is provided and an adhesive layer 16 is applied to a planar surface of said temporary carrier substrate 15. The temporary carrier 15 is preferably a large substrate, for example having a diameter of 200 mm or 300 mm, of which only a portion is shown in Figure 2. The carrier substrate 15 may be any substrate suitable as a support substrate in a grinding and CMP tool. The carrier substrate 15 may for example be a standard silicon or glass wafer of 200 mm or 300 mm in diameter. The adhesive layer 16 is a temporary adhesive, i.e. it enables releasably attaching components to the carrier substrate 15, hence the use of the term 'temporary carrier substrate'.

With reference to Figure 3, individual dies 3 are picked up from the tapes 9 and 10 and placed on the adhesive layer 16 so as to become temporarily attached at their front side to the carrier substrate 15. This can be done by known pick and place technology. As illustrated in Figure 3, not only dies from the wafers 1 and 2 shown in Figure 1 are placed on the carrier substrate 15, but also dies having other thicknesses, and which may originate from a third wafer, a fourth wafer, etc. At least a central portion of the carrier substrate 15 is thereby fully populated with dies 3 having different thicknesses. According to various embodiments, the thickness difference between any two dies thus attached to the carrier substrate 15 is higher than or equal to one of the following values : 0 nm, 20 nm, 100 nm, 500 nm, 1 µm, and/or lower than one of the following values : 20 µm, 100 µm, 5 µm, 1 mm, 1.5 mm. Various embodiments are characterized by the thickness difference between any two dies attached to the temporary carrier substrate lying between any one of the lower limits and any one of the higher limits stated hereabove. In the present context, the thickness of an individual die is defined as the thickness of the die at the center of the die.

The distance between any pair of adjacent dies on the carrier substrate 15 is preferably between 0 cm and 5 cm The thickness of the dies 3 attached to the temporary carrier substrate 15 is preferably between 10 µm and 5 mm.

When at least a central portion of the carrier substrate 15 is fully populated, the substrate 15 is placed on a holding chuck of a grinding tool, and the back sides of the dies 3 are thinned by grinding the dies collectively. This may be followed by a collective CMP (chemical mechanical polishing) step in order to reach a high level of uniformity of the obtained thickness of the dies. As illustrated in Figure 4, the result is a carrier substrate 15 populated with dies of different origins which have a uniform thickness. According to various embodiments, the thickness difference between any two dies 3 on the temporary carrier substrate 15 after the thinning step is smaller than 1 µm, smaller than 500 nm, smaller than 100 nm, smaller than 20 nm or smaller than 10 nm. According to embodiments, the thickness of the dies 3 after collective thinning by collective grinding and possibly collective CMP is smaller than 100 µm, smaller than 50 µm, smaller than 20 µm, smaller than 10µm, or smaller than 3 µm.

In order to enable collective thinning, the temporary adhesive 16 needs to be sufficiently strong in order to maintain the dies 3 during the thinning step. Suitable adhesives include inorganic dielectrics such as SiN or organic polymers such as polysiloxanes, epoxy compounds or polycarbazoles.

As stated above, the method is not limited to embodiments wherein the dies 3 attached to the temporary carrier substrate 15 originate from different wafers having different thicknesses and/or different materials and/or different in-plane sizes. The method is applicable to dies originating from a single wafer and for example transferred by pick and place technology from a dicing tape to the temporary carrier substrate 15. The method is also applicable to dies originating from multiple identical wafers.

The method enables thinning physically separated dies down to thicknesses in the order of tens of micrometres, for example less than 20 µm or less than 10µm, with an accuracy within one µm, while still allowing handling of the dies in subsequent bonding processes. One example thereof is illustrated in Figures 5 to 8. The carrier substrate 15 with the dies attached thereto is flipped and attached to a second carrier substrate 20 provided also with a temporary adhesive 21. The first carrier substrate 15 is then removed, as illustrated in Figure 6, by releasing the adhesive 16, for example by heating. This would require that the adhesives 16 and 21 are different adhesives configured to be released by different release mechanisms, so that adhesive 21 remains intact while adhesive 16 is softened by heating. However, if a laser-based release mechanism is applied, the same adhesive can be used for layers 16 and 21. The invention is not limited to any particular release mechanism.

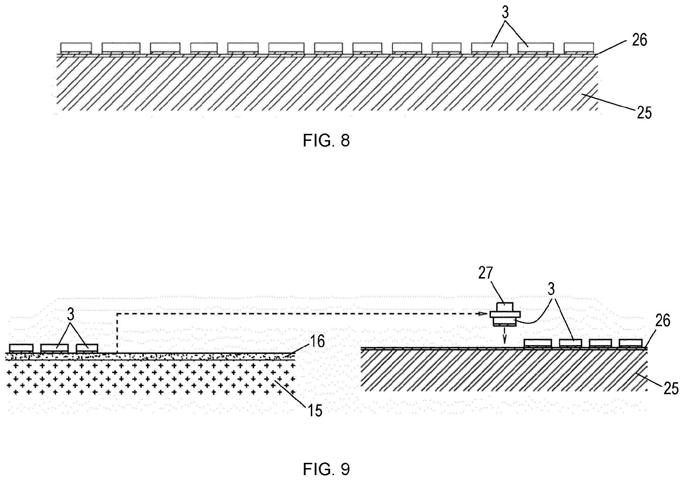

This may be followed by a cleaning step (not shown) to remove residues from the adhesive 16. With reference to Figure 7, the second carrier substrate 20 with the dies 3 attached thereto is then flipped and the dies are bonded to a support substrate 25 provided with an active portion 26 comprising bonding bumps or pads to which the dies are bonded in an electrically conductive way, for example by a hybrid bonding process known as such in the art. The support substrate 25 may for example comprise one or more interposer chips. Following this bonding step, the second carrier 20 is released by applying a release mechanism applicable to the adhesive 21, resulting in the assembly shown in Figure 8.

An alternative way of transferring the thinned dies 3 to a permanent support substrate 25 is by pick and place technology, as illustrated in Figure 9, wherein a pick-and-place tool 27 transfers dies one by one from the temporary carrier substrate 15 and places them onto the support substrate 25 to which the dies are bonded in a die-to-wafer bonding process.

As the method enables thinning dies collectively down to thicknesses in the order of a few micrometres or tens of micrometres, a die-to-wafer transfer method can be applied wherein dies are released from a temporary carrier substrate by illuminating the dies, for example by UV or laser light from the back side of the carrier. Such a method is described in patent publication document EP4199050. This would require that the temporary carrier substrate 15 is transparent for the applied light type and that the adhesive layer 16 is releasable by irradiation with these light sources.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for thinning a plurality of semiconductor dies (3), said dies having a front side and a back side, the method comprising the consecutively applied steps of :
- producing one or more wafers (1,2), each wafer comprising a plurality of semiconductor dies (3),
- attaching the one or more wafers (1,2) respectively to one or more dicing tapes (7,8),
- dicing the one or more wafers (1,2) to obtain a plurality of separate dies (3) on the one or more dicing tapes (7,8),
- transferring a plurality of said dies (3) to a carrier substrate (15) by removably attaching the front side of said dies (3) to said carrier substrate (15),
- collectively thinning the dies (3) attached to the carrier substrate (15) from the back side of said dies.

2. The method according to claim 1, wherein a plurality of said wafers (1,2) is provided, each wafer comprising a plurality of semiconductor dies (3), the wafers having at least two different thicknesses, and wherein dies originating from wafers (1,2) having a different thickness are attached to said carrier substrate (15).

3. The method according to claim 1 or 2, wherein a releasable adhesive layer (16) is produced on a surface of the carrier substrate (15) and wherein the dies (3) are attached to said releasable adhesive layer (16).

4. The method according claim 3, wherein said releasable adhesive layer (16) is formed of an inorganic dielectric material or an organic polymer material.

5. The method according to any one of the preceding claims, wherein the thinning step comprises collectively grinding the dies (3) on the back side of the dies.

6. The method according to claim 5, wherein after said grinding, the thinning step further comprises collectively applying chemical mechanical polishing on the back side of the dies (3).

7. The method according to any one of the preceding claims, wherein the thickness difference between any two dies (3) attached to the carrier substrate (15) before the thinning step lies between 0 mm and 1.5 mm.

8. The method according to any one of the preceding claims, wherein the distance between any two adjacent dies (3) on the carrier substrate (15) lies between 0 cm and 5cm.

9. The method according to any one of the preceding claims, wherein the thickness of the dies (3) after the thinning step is smaller than 3 µm.

10. A method for bonding multiple dies (3) to a support substrate (25) by an electrically conductive bond, comprising the steps of :
- thinning said multiple dies (3) collectively by the method according to any one of the preceding claims, wherein said carrier substrate (15) is now referred to as a first carrier substrate,
- releasably attaching the dies (3) to a second carrier substrate (20),
- thereafter releasing the dies from the first carrier substrate (15),
- thereafter bonding the dies collectively to the support substrate (25),
- thereafter releasing the dies from the second carrier substrate (20).

11. A method for bonding multiple dies (3) to a support substrate (25) by an electrically conductive bond, comprising the steps of :
- thinning said multiple dies (3) collectively by the method according to any one of the preceding claims,
- transferring the dies one by one from the carrier substrate (15) to the support substrate (25).

12. The method according to claim 11, wherein the carrier substrate (15) is transparent, and wherein the dies (3) are attached to the carrier substrate (15) by a light-releasable adhesive, and wherein the dies are transferred one by one to the support substrate (25) by illuminating the dies through the carrier substrate.
